# EUROPEAN PATENT SPECIFICATION

(11) **EP 0 358 871 B1**
(45) Date of publication and mention of the grant of the patent: **30.09.1998**
(21) Application number: 89112360.6
(22) Date of filing: 06.07.1989
(51) Int. Cl.: G03F 7/004, G03F 7/022

(54) **Radiation-sensitive positive resist composition**
Strahlungsempfindliche, positiv arbeitende Resistzusammensetzung
Compositions pour réserves positives sensibles aux rayonnements

(30) Priority: 07.07.1988 JP 169477/88; 27.12.1988 JP 331074/88
(43) Date of publication of application: 21.03.1990
(73) Proprietor: Sumitomo Chemical Company, Limited, Chuo-ku Osaka 541-8550 (JP)
(72) Inventor: Ozaki, Haruyoshi, Toyonaka-shi Osaka-fu (JP); Oi, Fumio, Ashiya-shi Hyogo-ken (JP); Uetani, Yasunori, Minoo-shi Osaka-fu (JP); Hanabata, Makoto, Kawabe-gun Hyogo-ken (JP); Hioki, Takeshi, Tondabayashi-shi Osaka-fu (JP)
(74) Representative: VOSSIUS & PARTNER

(56) References cited:
- EP-A- 211 667
- EP-A- 239 423
- US-A- 3 188 210
- US-A- 4 390 664
- US-A- 4 695 408
- PATENT ABSTRACTS OF JAPAN vol. 9, no. 323 (P-414)(2046) 18 December 1985 & JP-A-60 150 047

## Description

The present invention relates to a radiation-sensitive positive resist composition which is sensitive to ultraviolet rays, far ultraviolet rays (excimer laser), electron rays, ion beams and radio active rays such as X-rays.

Recently, particularly in the production of integrated circuits, miniaturization has been proceeded as the integration level is increased, which results in demands for formation of patterns of submicron order and more excellent resolving power. According to the conventional processes for the production of integrated circuits, light exposure is accomplished by placing a mask with intimate contact to a substrate such as a silicon wafer. It is said that this process cannot make patterns thinner than 2 µm. Instead of such conventional processes, the reduction projection exposure system attracts attentions. According to this new system, a pattern of a master mask (reticle) is projected on the substrate with reduction by a lens system, whereby exposure is accomplished. This system realizes a resolving power of 1 µm.

A serious problem in this system is low throughput. Namely, in this system, the total exposure time for exposing a wafer is very long because of divided and repeated light exposure unlike a batch light exposure system such as the conventional mask contact printing method.

For solving this problem, not only the improvement of the apparatus but also increase of sensitivity of the resist to be used are important. If the exposure time can be shortened by the increase of the sensitivity, the throughput and in turn the yield can be improved.

On the other hand, as the distance between the adjacent two lines is decreased with the increase of the integration level, a dry etching is predominantly used rather than a wet etching. Then, the photoresist should have better heat resistance than ever.

When the positive photoresist now in practical use is checked from this standpoint, its sensitivity, resolving power and heat resistance are not necessarily satisfactory. Generally, the positive photoresist has lower sensitivity than the negative photoresist and improvement of the sensitivity of the former is desired.

For increasing the sensitivity, it is easiest to decrease a molecular weight of a novolak resin used in the positive photoresist. The decrease of the novolak resin molecular weight accelerates dissolution of the photoresist in an alkaline developing solution so that the apparent sensitivity of the photoresist is increased.

This method, however, has a very serious disadvantage such as deterioration of the heat resistance of the photoresist. Moreover, it encounters some problems such as large film thickness loss in an unexposed area (reduction of so-called film thickness retention), the worse shape of the pattern, deterioration of the γ-value because of small difference of the dissolving rates in the developing solution between the exposed area and the unexposed area.

In view of this, positive resists satisfying sensitivity, resolving power and heat resistance at the same time have not been on the market up to now. Trying to improve one of these three characteristics, at least one of the remaining characteristics tends to be impaired.

EP-A-0211667 relates to a radiation-sensitive resin composition comprising a solution of an alkali-soluble resin and a radiation-sensitive compound in a solvent comprising a monooxymonocarboxylic acid ester. This composition has a high storage stability (i.e., a very small amount of fine particles are formed during storage) and is suited for use as a resist for making integrated circuits.

JP-A-60 150 047 relates to a compound of the formula 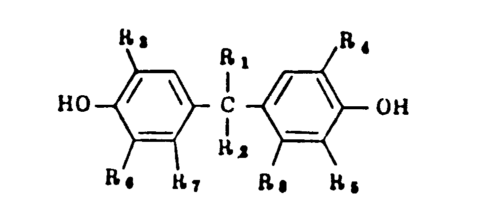 (R₁ and R₂ are H and C₁-C₂ alkyl, R_{3,} R₄, R₅, R₆, R₇, and R₈ are H_{,} hydroxyl, C₁-C₈ alkyl, halogen, C₁- C₃ alkoxyl, and nitro groups) which is additionally incorporated into a positive photo-sensitive composition containing an o-quinonediazide compound such as an ester of benzoquinone(1,2)-diazide sulfonic chloride and a pyrogallol-acetone resin.

EP-A-0 239 423 describes a positive type radiation-sensitive resin composition comprising an alkali-soluble novolac resin and a 1,2-quinonediazide compound, characterized in that said alkali-soluble novolac resin is a resin produced by condensing a carbonyl compound and a phenol mixture comprising 6 to 94 mole % of m-cresol and 94 to 6 mole % at least one compound represented by the formula (I) other than m-cresol: 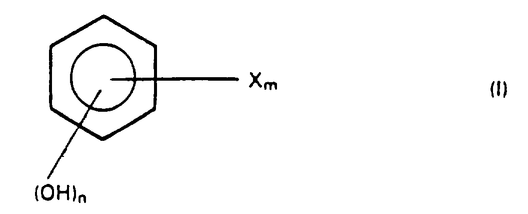 wherein X is -CH₃, -C₂H₅, -C(CH₃)₃, -CO₂CH₃ or -CO₂C₂H₅; n is an integer satisfying 3 ≧ n ≧ 1; and m is an integer satisfying 3 ≧ m ≧ 1, in which resin when the polystyrenereduced molecular weight is determined by a gel permeation chromatography using a monodisperse polystyrene as the standard, maximum values a, b and c present, respectively, in the molecular weight ranges of 6,300 to 25,000, 2,500 to 6,000 and 150 to 900 in the molecular weight distribution curve obtained satisfv the following relationships: a/b = 0-1.5 and c/b=1.4-2.

US-A-4 390 664 relates to a curable epoxy resin composition of substantially improved curing time and high temperature properties comprising a polyepoxide of the formula: 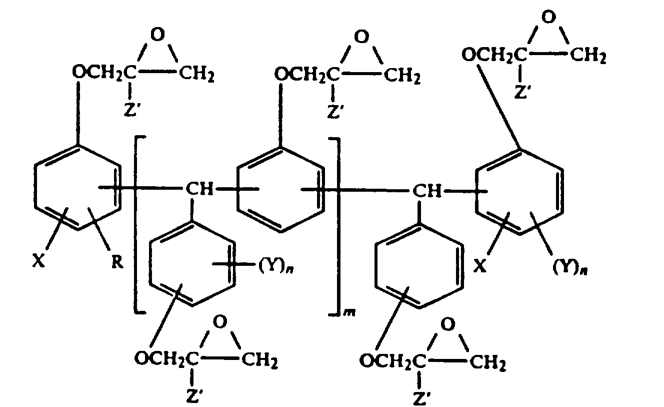 wherein R is H or an alkyl of up to about 18 carbon atoms, X is H or halogen, Y is an alkyl of up to about 18 carbon atoms or methoxy, Z' is H or CH₃, m is an integer of not less than 1, n is an integer of up to 2, and from about 25 to about 120 parts by weight, per 100 parts by weight of the polyepoxide, of an epoxy resin hardener.

One object of the present invention is to provide an alkali-soluble resin and a positive resist composition containing such a resin which can overcome the above problems associated with the conventional positive resist compositions and which has better sensitivity, improved resolving power and heat resistance.

Accordingly, the present invention provides a positive resist composition which comprises a 1,2-quinone diazide compound and an alkali-soluble novolak resin having a weight average molecular weight measured by GPC of not less than 2000 as converted to polystyrene which is a condensation product of a phenol compound and formaldehyde, and a polyphenol compound (I) of the general formula:

X-α-H (I)

wherein X is a group of the formula: 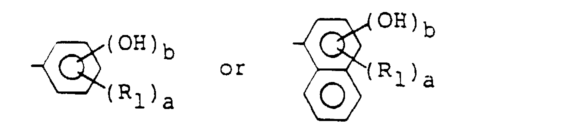 and α is a divalent group which comprises a repeating unit of the formula: 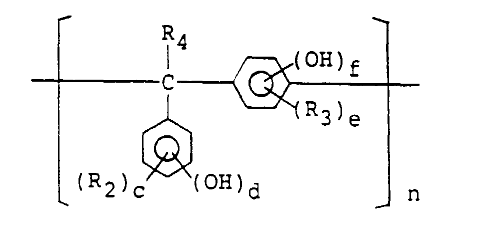 or 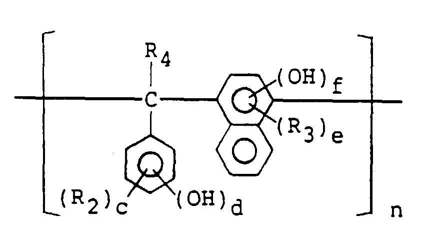 in which n is a number of not less than 1; a, b, c, d, e and f are the same or different and a number of 0-3, provided that d + f is not less than 1; R₁, R₂ and R₃ are the same or different and a C₁-C₁₈ alkyl group, a C₁₋₁₈ alkoxy group, a carboxyl group or a halogen atom; R₄ is a hydrogen atom, a C₁-C₁₈ alkyl group or an aryl group, wherein the content of the polyphenol compound (I) is 4 to 40 parts by weight per 100 parts of the total weight of said alkali-soluble novolak resin and said polyphenol compound (I).

In the compound (I), preferably, each of R₁, R₂ and R₃ is a C₁-C₅ alkyl group, a methoxy group, an ethoxy group or a carboxyl group. R₄ is preferably a hydrogen atom, a C₁-C₅ alkyl group or a C₆-C₁₀ aryl group.
n is preferably not more than 5 because of a better sensitivity, a better resolving power and better heat resistance of the produced resist in combination with a known alkali-soluble resin.

When n is not more than 5, preferably b, d and f are each not less than 1.

Among the compounds (I), the following compounds are preferably used: 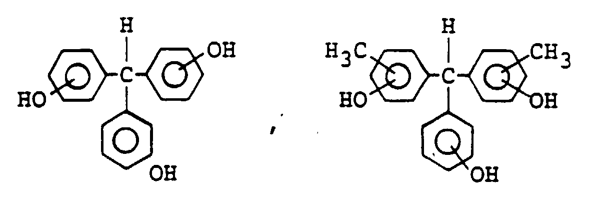 and 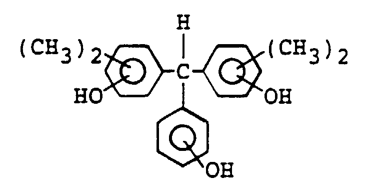 More preferably, 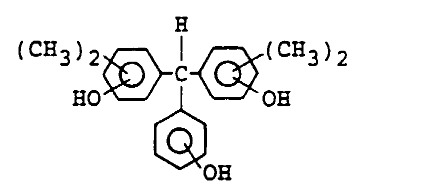 is used.

As far as the polyphenol compound (I) keep its alkali-solubility, the group α of the polyphenol compound (I) may comprise other repeating units such as the repeating units (A) in which both of d and f are 0 in addition to the above repeating unit(s).

The polyphenol compound (I) is obtainable by a condensation reaction of a phenol compound (II) with a carbonyl compound in the presence of an acid catalyst.

Examples of the phenol compound (II) which is condensed with the carbonyl compound include phenol, o-cresol, m-cresol, p-cresol, 3,5-xylenol, 2,5-xylenol, 2,3-xylenol, 2,4-xylenol, 2,6-xylenol, 3,4-xylenol, 2,3,5-trimethylphenol, 4-tert.-butylphenol, 2-tert.-butylphenol, 3-tert.-butylphenol, 2-methylresorcinol, 4-methylresorcinol, 5-methylresorcinol, 4-n-hexylresorcinol, 4-dodecylresorcinol, 4-tert.-buthylcathecol, 4-methoxyphenol, 3-methoxyphenol, 2-methoxyphenol, 2-methoxypyrocathecol, 2-methoxyresorcinol, 3-methoxyresorcinol, 2,3-dimethoxyphenol, 2,5-dimethoxyphenol, 3,5-dimethoxyphenol, 2-chloro-5-methylphenol, methyl gallate, ethyl gallate, methyl 3-methoxy-4,5-dihydroxy benzoate, ethyl 4-methoxy-3,5-dihydroxy benzoate, ethyl 3,4-dimethoxy-5-hydroxy benzoate, methyl 3,5-dimethoxy-4-hydroxy benzoate, ethyl 3,5-dimethoxy-4-hydroxy benzoate, 3-ethylphenol, 2-ethylphenol, 4-ethylphenol, 2,3,5-triethylphenol, 3,5-diethylphenol, 2,5-diethylphenol and 2,3-diethylphenol naphtol.

These phenol compounds may be used alone or in combination.

Examples of the carbonyl compound include benzaldehyde, o-hydroxybenzaldehyde, m-hydroxybenzaldehyde, p-hydroxybenzaldehyde, 2,3-dihydroxybenzaldehyde, 2,4-dihydroxybenzaldehyde, 2,5-dihydroxybenzaldehyde, 3,4-dihydroxybenzaldehyde, 4-carboxybenzaldehyde, acetophenone, o-hydroxyacetophenone, m-hydroxyacetophenone, p-hydroxyacetophenone, octanophenone, 2,4-dihydroxyacetophenone, 2',5'-dihydroxyacetophenone, 2'6'-dihydroxyacetophenone, o-methoxybenzaldehyde, m-methoxybenzaldehyde, p-methoxybenzaldehyde, 2,3-dimethoxybenzaldehyde, 2,4-dimethoxybenzaldehyde, 2,5-dimethoxybenzaldehyde, 3,4-dimethoxybenzaldehyde, 2'4'-dimethoxyacetophenone, 2'5'-dimethoxyacetophenone, 3',4'-dimethoxyacetophenone, 3'5'-dimethoxyacetophenone and 2,2'-dihydroxybenzaldehyde.

These carbonyl compounds may be used alone or in combination.

Examples of the acid catalyst to be used in this condensation reaction include organic or inorganic acids (e.g. oxalic acid, formic acid, p-toluenesulfonic acid, trichloroacetic acid, hydrochloric acid, sulfuric acid, perchloric acid and phosphoric acid and salts of divalent metals (e.g. zinc acetate and magnesium acetate).

Among them hydrochloric acid is preferred, since selectivity is good and a reaction rate can be controlled easily by changing a concentration of hydrochloric acid.

The amount of the carbonyl compound to be used in the condensation reaction is 0.02 to 3 moles per mole of the phenol compound (II). The amount of the acid catalyst to be used in the condensation reaction is 0.01 to 0.7 mole per mole of the carbonyl compound.

The condensation reaction may be carried out at a temperature of from 30°C to 250°C for from 2 to 30 hours.

The reaction may be carried out in bulk or in a suitable solvent.

The suitable solvent includes water, alcohols (e.g. methanol, ethanol, isopropanol, n-butanol and isoamyl alcohol), ethylcellosolve acetate, ethylcellosolve, methylcellosolve, methyl isobutyl ketone, methyl ethyl ketone, hexane, cyclohexane, heptane, benzene, toluene and xylene.

Preferably, the amount of the solvent is 10 to 1,000 parts by weight per 100 parts by weight of the phenol compound and the carbonyl compound in total.

When the condensation reaction of 2,5-xylenol with o-hydroxybenzaldehyde is carried out in toluene in the presence of p-toluenesulfonic acid as the catalyst, the amount of toluene is 50 to 500 parts by weight per 100 parts by weight of 2,5-xylenol, and the amount of 2,5-xylenol is 2.0 to 5.0 moles, preferably 3.0 to 4.0 moles per mole of o-hydroxybenzaldehyde. When the condensation reaction of 2,5-xylenol with o-hydroxybenzaldehyde is carried out in methanol in the presence of p-toluenesulfonic acid as the catalyst, the amount of methanol is 50 to 1,000 parts by weight of 2,5-xylenol, and the amount of 2,5-xylenol is preferably 2.0 to 4.0 moles per mole of 0-hydroxybenzaldehyde. The amount of p-toluenesulfonic acid is 0.01 to 0.1 mole, preferably 0.02 to 0.03 mole per mole of o-hydroxybenzaldehyde. This reaction may be carried out at a temperature of from 50°C to the refluxing temperature for 5 to 30 hours.

After removal of metal ions, a condensation product can be purified by a suitable method such as recrystallization and reprecipitation.

A method of removal of the metal ions is as follows:

The product is dissolved in an organic solvent which can be separated from a mixture with water and washed with ion-exchanged water. Examples of such organic solvent include methyl isobutyl ketone, ethylcellosolve acetate and ethyl acetate.

Another method of removal of the metal ions is as follows:

The product is dissolved in an organic solvent which is not separated from a mixture with water, and charged into ion-exchanged water to precipitate the product. Examples of such organic solvent include methanol, ethanol and acetone. This method is preferable because the removal of metal ion and purification of the condensation product are done at the same time.

The amount of the condensation product of the formula: 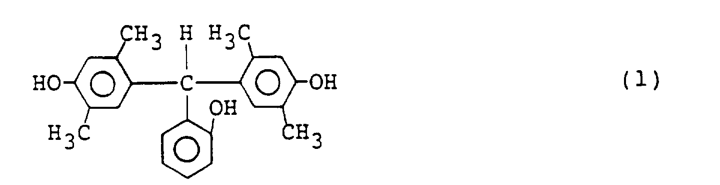 is 4 to 70 parts, preferably 10 to 40 parts by weight based on 100 parts by weight of the condensation product (1) and the alkali-soluble resin.

The positive resist composition of the present invention contains at least one alkali-soluble resin as defined above which is different from the polyphenol compound (I). Especially when the polyphenol compound wherein n is not more than 5 in the general formula (A), the amount of the polyphenol compound (I) is 4 to 40 parts by weight based on 100 parts by weight of a total of the alkali-soluble resin, namely the polyphenol compound (I) and the other alkali-soluble resin.

When the amount of the polyphenol compound (I) is less than 4 parts by weight, it is difficult to develop the photoresist because of decrease of solubility in the developing solution which mainly consist of an alkali solution. When the amount of the polyphenol compound (I) exceeds 40 parts by weight, it is difficult to make the pattern because unirradiated parts are also dissolved easily in the developing solution.

The novolak resin as used in claim 1 is prepared by an addition condensation reaction of a phenol compound with formaldehyde. Specific examples of the phenol compound used as one of the raw materials for the synthesis of the novolak resin include phenol, o-cresol, m-cresol, p-cresol, 2,5-xylenol, 3,5-xylenol, 3,4-xylenol, 2,3,5-trimethylphenol, 4-tert.-butylphenol, 2-tert.-butylphenol, 3-tert.-butylphenol, 3-ethylphenol, 2-ethylphenol, 4-ethylphenol, 2-naphthol, 1,3-dihydroxynaphthalene, l,7-dihydroxynaphthalene and 1,5-dihydroxynaphthalene. These phenols may be used alone or in combination.

The addition condensation reaction of the phenol with formaldehyde can be carried out according to the usual method. This reaction is carried out at a temperature of from 60 to 120°C for 2 to 30 hours. Organic acids, inorganic acids or divalent metal salts may be used as catalysts. Specific examples of the catalysts are oxalic acid, hydrochloric acid, sulfuric acid, perchloric acid, p-toluenesulfonic acid, trichloroacetic acid, phosphoric acid, formic acid, zinc acetate and magnesium acetate.

A novolak resin having a high molecular weight is used. Such a high molecular weight novolak resin having a weight average molecular weight of not less than 2,000 as converted to polystyrene can be prepared by removing from the reaction product through crystallization or fractionation 30 to 90 % by weight of lower molecular weight fractions based on the weight of the whole novolak resin.

The 1,2-quinone diazide compound to be used as a sensitizer in the positive resist composition of the present invention is not limited. Specific examples of the 1,2-quinone diazide compound are 1,2-benzoquinone diazide-4-sulfonic acid ester, 1,2-naphthoquinone diazide-4-sulfonic acid ester and 1,2-naphthoquinone diazide-5-sulfonic acid ester.

Above esters may be prepared by a per se conventional method. For example, the ester is prepared by a condensation reaction of a compound having a hydroxyl group with 1,2-naphthoquinone diazide sulfonyl chloride or benzoquinone diazide sulfonyl chloride in the presence of a weak alkali.

Examples of the compound having a hydroxyl group are hydroquinone, resorcinol, phloroglucin, 2,4-dihydroxybenzophenone, 2,3,4-trihydroxybenzophenone, 2,3,4,4'-tetrahydroxybenzophenone, 2,2',4,4'-tetrahydroxybenzophenone, bis(p-hydroxyphenyl)methane, bis(2,4-dihydroxyphenyl)-methane, bis(2,3,4-trihydroxyphenyl)methane, 2,2-bis(2,4-dihydroxyphenyl)propane, 2,2-bis(2,3,4-trihydroxyphenyl)-propane and hydroxyflavan compounds of the formula:

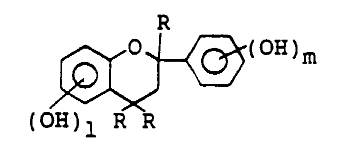

The positive resist composition of the present invention may contain two or more 1,2-quinonediazide compounds in combination.

The positive resist composition is prepared by mixing and dissolving the 1,2-quinonediazide compound and the alkali-soluble resin including the polyphenol (I) in a solvent.

The amount of the 1,2-quinonediazide compound is 5 to 100, preferably 10 to 50 parts by weight per 100 parts by weight of the alkali-soluble resin.

When the amount of the 1,2-quinonediazide compound is less than 5 parts by weight, it is difficult to make the pattern because of easy dissolution of the composition in the developing solution. When the amount of the 1,2-quinonediazide compound exceeds 100 parts by weight, an irradiation dose has to be increased because short time irradiation cannot decompose all the 1,2-quinonediazide compound added. The large irradiation dose will deteriorate the sensitivity.

Preferably, the used solvent evaporates at a suitable drying rate to give a uniform and smooth coating film. Such the solvent includes ethylcellosolve acetate, methylcellosolve acetate, ethylcellosolve, methylcellosolve, propyleneglycol monomethyl ether acetate, butyl acetate, methyl isobutyl ketone and xylene.

To the positive photoresist composition obtained by the foregoing method, small amounts of additives, such as resins and dyes may be added if desired.

The resist composition of the present invention has better sensitivity and also improved resolving power and heat resistance in comparison with the conventional ones.

The present invention will be illustrated more in detail with the following Examples, but it is not limited to these Examples. In Examples, "parts" are by weight unless otherwise indicated.

### Synthesis Example 1

Into a 500 ml three-necked flask equipped with a stirrer, a condenser, a water separator and a thermometer, phenol (141 g), p-hydroxybenzaldehyde (9.2 g), p-toluenesulfonic acid (0.7 g) and cyclohexane (28 g) were charged and stirred on an oil bath at 80°C for 4 hours while removing condensed water. After neutralization and washing with water, water and residual phenol were removed under reduced pressure to obtain a novolak resin (14.1 g) on a palette.

The weight average molecular weight of the novolak resin measured by the GPC was 550 as converted to polystyrene.

### Synthesis Example 2

Into the same flask as used in Synthetic Example 1, phenol (106 g), m-cresol (41 g), p-hydroxybenzaldehyde (9 g), p-toluenesulfonic acid (0.7 g) and cyclohexane (29 g) were charged and stirred on an oil bath at 80°C for 4 hours while removing condensed water. After neutralization and washing with water, water, residual phenol and residual m-cresol were removed under reduced pressure to obtain a novolak resin (17.0 g) on a palette.

The weight average molecular weight measured by the GPC was 370 as converted to polystyrene.

### Synthesis Example 3

Into the same flask as used in Synthetic Example 1, m-cresol (162.2 g), p-hydroxybenzaldehyde (9.2 g), p-toluenesulfonic acid (0.7 g) and cyclohexane (34 g) were charged and stirred on an oil bath at 80°C for 4 hours while removing condensed water. After neutralization and washing with water, water and residual m-cresol were removed under reduced pressure to obtain a novolak resin (14.6 g) on a palette.

The weight average molecular weight measured by the GPC was 340 as converted to polystyrene.

### Synthesis Example 4

Into the same flask as used in Synthetic Example 1, 2,5-xylenol (134.0 g), salicylaldehyde (33.7 g), p-toluenesulfonic acid (0.83 g) and toluene (268 g) were charged and stirred on an oil bath at 115°C for 16 hours while removing condensed water. The resulting mixture was filtered at a temperature of 50 to 60°C to obtain a crude cake.

The crude cake was dissolved in methanol (580 g) at a temperature of 20 to 25°C and poured in ion-exchanged water (1450 g). Thereafter, the resulting solution was filtered and dried to obtain the compound of the formula (1) (89.3 g). Yield, 98.0 % (based on salicylaldehyde). 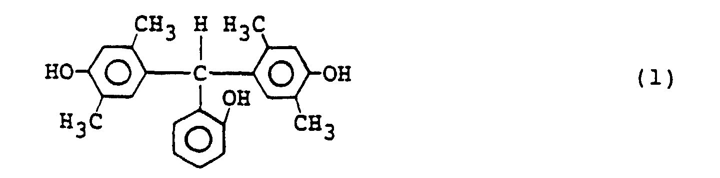
MS: m/e = 348 (M⁺)
NMR in acetone-d₆ (standard: TMS): δ (ppm) = 2.04 (s, 12H), 5.85 (s, 1H), 6.52 (s, 2H), 6.63 (s, 2H), 6.74 (m, 2H), 6.83 (d, 1H), 7.05 (m, 1H), 7.73 (s, 1H), 8.09 (s, 1H)
Melting point: 274-275°C

### Synthesis Example 5

Into a 5 liter three-necked flask equipped with a stirrer, a condenser, a water separator and a thermometer, 3,4-xylenol (1094 g), salicylaldehyde (488 g) and 20 % hydrochloric acid (1955 g) were charged and stirred on an water bath at a temperature of 50 to 55°C for 43 hours while removing condensed water. The resulting mixture was cooled down to the room temperature and extracted with ethyl acetate (4 1). The hydrochloric acid layer was separated, and the organic layer was washed four times with ion-exchanged water (4 1). After concentration, toluene (5500 g) was added to the solution and stirred at a temperature of 70 to 75°C for 2 hours. Then the resulting solution was cooled down to the room temperature and filtered to obtain a wet cake. The wet cake was mixed with toluene (2500 g) and ethyl acetate (125 g) and stirred at a temperature of 70 to 75°C for 2 hours. After cooled down to the room temperature, the mixture was filtered and dried to obtain a cake of a compound represented by the following formula (2) (1211 g). The purity by HPLC was 98.2 %. 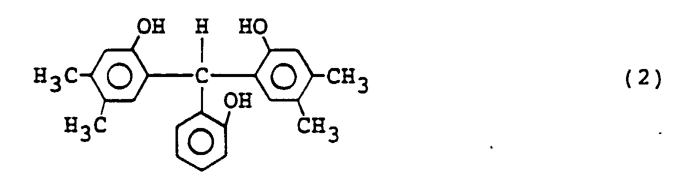
NMR in acetone-d₆ (standard: TMS): δ (ppm) = 2.05 (s, 6H), 2.12 (s, 6H), 6.35 (s, 2H), 6.58 (s, 2H), 6.62 (s, 2H), 6.70 (m, 1H), 6.80 (m, 2H) 7.00 (m, 1H), 7.50 (s, 2H), 7.82 (s, 1H)
Melting point: 220°C

### Synthesis Example 6

Into a one liter flask equipped with a stirrer, a condenser, a water separator and a thermometer, 2,6-xylenol (244 g), salicylaldehyde (61.1 g), and conc. hydrochloric acid (300 g) were charged and stirred on a water bath at a temperature of 45 to 50°C for 6 hours while removing condensed water. The resulting mixture was cooled down to the room temperature and subjected to decantation. The solution was extracted with ethyl acetate (4 1). The hydrochloric acid layer was separated, and the organic layer was washed four times with ion-exchanged water (1 liter). After concentration, toluene (520 g) was added to the solution and stirred at a temperature of 70 to 75°C for 2 hours. Then, the resulting solution was cooled down to the room temperature and filtered to obtain a wet cake. The wet cake was mixed with toluene (430 g) and stirred at a temperature of 70 to 75°C for 2 hours. Thereafter, the mixture was cooled down to the room temperature, filtered and dried to obtain a wet cake. The wet cake was washed with toluene (200 g) and dried to obtain a cake of a compound represented by the formula (3) (124 g). The purity by HPLC was 97.6 %. 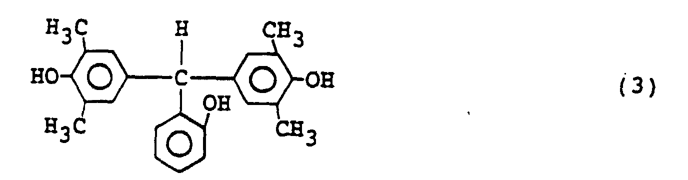
NMR in acetone-d₆ (standard: TMS): δ (ppm) = 2.14 (s, 12H), 5.56 (s, 1H), 6.67 (s, 4H), 6.80 (m, 1H), 7.03 (s, 2H), 8.06 (s, 1H)
Melting point: 203-204°C

### Synthesis Example 7

In a 1000 ml three-necked flask, were added m-cresol (149 g), p-cresol (121 g), ethylcellosolve acetate (252 g) and 5 % aqueous oxalic acid solution (30.4 g). Then, to the mixture, an aqueous solution of formalin (37.0 %) (147.8 g) was dropwise added over 40 minutes while heating and stirring on an oil bath kept at 90°C. Thereafter, the reaction mixture was heated while stirring for further 7 hours. After neutralization, washing with water and removing water, a solution of a novolak resin in ethylcellosolve acetate was obtained.

The weight average molecular weight measured by the GPC was 9600 as converted to polystyrene.

### Synthesis Example 8

The ethyl cellosolve acetate solution of novolak resin obtained in Synthetic Example 7 (the content of the novolak resin, 41.2 %) (120 g) was added to a 3 liter separable flask, and then ethylcellosolve acetate (868.8 g) and n-heptane (544.6 g) were added. After stirring for 30 minutes at 20°C, the resulting mixture was kept standing and separated. n-Heptane in the recovered lower layer was removed by an evaporator to obtain a novolak resin in ethyl cellosolve acetate.

The weight average molecular weight measured by the GPC was 15500 as converted to polystyrene. Through the separation operation, 75 % of the lower molecular weight fractions were removed.

### Example 1-7 and Comparative Example 1 and 2

Each of the compounds obtained in Synthetic Examples 1-6 and the novolak resins obtained in Synthetic Example 7-8 was dissolved together with a sensitizer in ethyl cellosolve acetate in amounts in Table 1 to prepare a resist solution. The amount of the solvent was regulated to form a film having a thickness of 1.28 µm when the resist solution was applied under the coating conditions below.

Each composition was filtered through a Teflon (trade mark) filter of 0.2 µm in pore size to prepare a resist solution. The solution was then coated on a silicon wafer, which had been rinsed in a usual manner, by means of a spinner at 4000 rpm. The coated silicon wafer was baked for one minute on a vacuum adsorption-type hot plate kept at 100°C and exposed to light with varying the exposure time stepwise at each shot by means of a reduction projection exposure apparatus with a 350 W extra-high pressure mercury lamp as a light source. Thereafter, the silicon wafer was developed in a developing solution (SOPD manufactured by Sumitomo Chemical Company, Limited) to obtain a positive pattern. After rinsing and drying, the amount of film thickness loss for each shot was plotted against the exposure time to calculate sensitivity. The film thickness retention was calculated from the remained film thickness in the unexposed area. Also, the silicon wafer having a resist pattern was placed for 30 minutes in a clean oven set at various temperatures in the air, and the heat resistance was evaluated by observing the resist pattern by means of a scanning microscope.

These results are collectively shown in Table.

It is seen from the results in Table that balance between the sensitivity and heat resistance in the Examples is markedly improved in comparison with Comparative Examples.

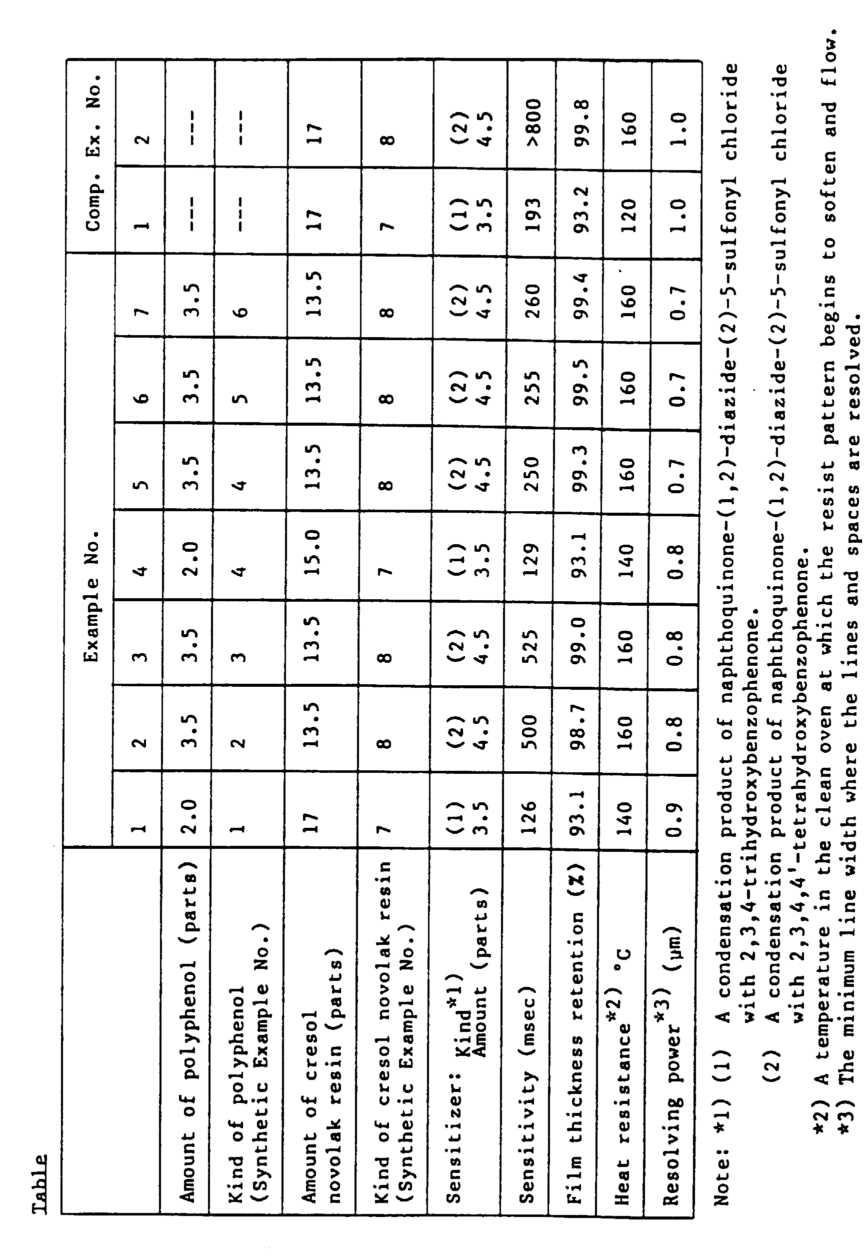

## Claims

1. A positive resist composition which comprises a 1,2-quinone diazide compound and an alkali-soluble novolak resin having a weight average molecular weight measured by GPC of not less than 2000 as converted to polystyrene which is a condensation product of a phenol compound and formuldehyde, and a polyphenol compound (I) of the general formula:
X-α-H (I)
wherein X is a group of the formula: 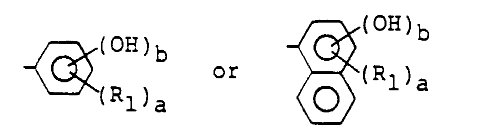 and α is a divalent group which comprises a repeating unit of the formula: 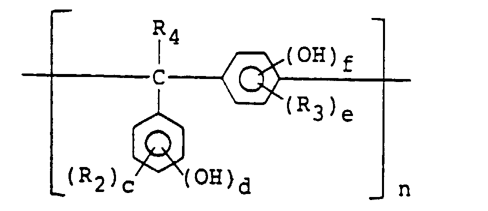 or 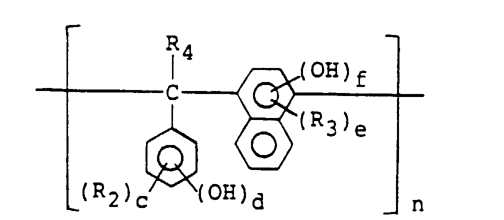 in which n is a number of not less than 1; a, b, c, d, e and f are the same or different and a number of 0-3, provided that d + f is not less than 1; R₁, R₂ and R₃ are the same or different and a C₁-C₁₈ alkyl group, a C₁₋₁₈ alkoxy group, a carboxyl group or a halogen atom; R₄ is a hydrogen atom, a C₁-C₁₈ alkyl group or an aryl group, wherein the content of the polyphenol compound (I) is 4 to 40 parts by weight per 100 parts of the total weight of said alkali-soluble novolak resin and said polyphenol compound (I).

2. The positive resist composition according to claim 1, wherein X is a group of the formula : 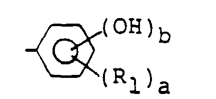 wherein R₁, a and b are the same as defined above, and α is a divalent group which comprises a repeating unit of the formula: 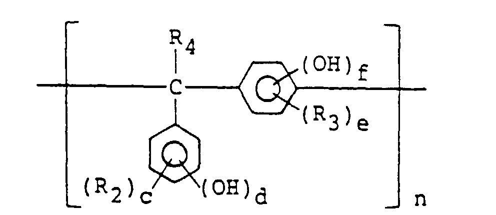 in which R₂, R₃, R₄, d, e, f and n are the same as defined above.

3. The positive resist composition according to claim 1, wherein n in the formula (A) is not less than 1 and not larger than 5.

4. The positive resist composition according to claim 1, wherein the polyphenol compound (I) is at least one compound of the formula: 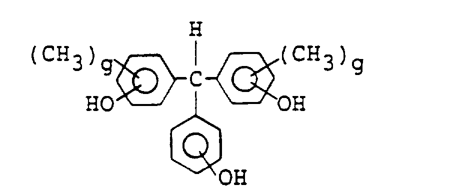 wherein g is 0, 1 or 2.

5. The positive resist composition according to claim 5, wherein the polyphenol compound (I) is the compound of the formula:

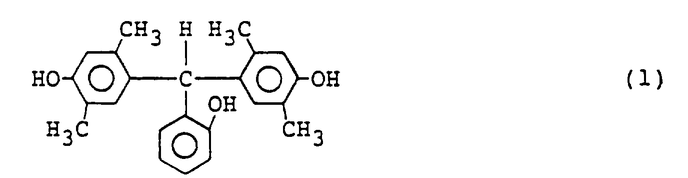

6. The positive resist composition according to claim 5, wherein the polyphenol compound (I) is the compound of the formula:

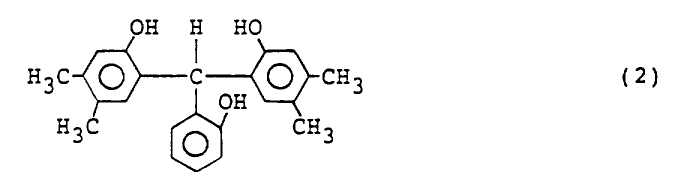

7. The positive resist composition according to claim 5, wherein the polyphenol compound (I) is the compound of the formula:

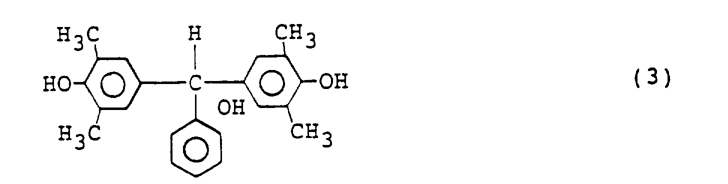

8. The positive resist composition according to claim 1, wherein the novolak resin, which is a high molecular weight novolak resin having a weight average molecular weight measured by GPC of not less than 2,000 as converted to polystyrene, is prepared by removing from the whole resin 30 to 90 % by weight of low molecular weight fractions based on the weight of the whole novolak resin.

## Patentansprüche

1. Positiv arbeitende Resistzusammensetzung, umfassend eine 1,2-Chinondiazidverbindung und ein alkalilösliches Novolakharz mit einem Gewichtsmittel des Molekulargewichts, gemessen mit GPC, von nicht weniger als 2000, umgerechnet auf Polystyrol, das ein Kondensationsprodukt einer Phenolverbindung und von Formaldehyd ist, und eine Polyphenolverbindung (I) der allgemeinen Formel:
X-α-H (I)
in der X ein Rest der Formel: 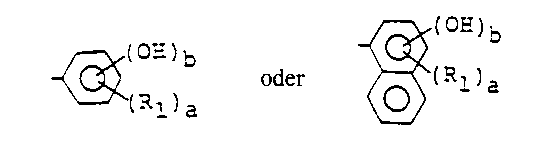 und α ein zweiwertiger Rest ist, der eine sich wiederholende Einheit der Formel: 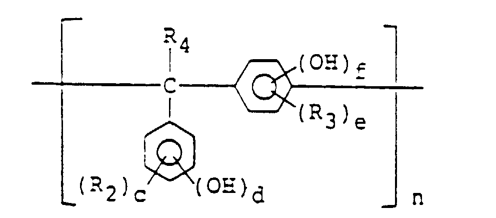 oder 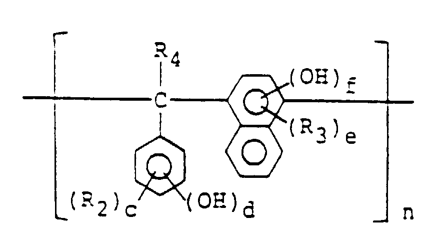 umfaßt, in der n eine Zahl von nicht weniger als 1 ist; a, b, c, d, e und f gleich oder verschieden sind und eine Zahl von 0 - 3 sind, mit der Maßgabe, daß d + f nicht weniger als 1 ist; R₁, R₂ und R₃ gleich oder verschieden sind und ein C₁₋ C₁₈-Alkylrest, ein C₁-C₁₈-Alkoxyrest, ein Carboxylrest oder ein Halogenatom sind; R₄ ein Wasserstoffatom, ein C₁-C₁₈-Alkylrest oder ein Arylrest ist, wobei der Gehalt der Polyphenolverbindung (I) 4 bis 40 Gew.-Teile nro 100 Gew.-Teile des Gesamtgewichts des alkalilöslichen Novolakharzes und der Polyphenolverbindung (I) beträgt.

2. Positiv arbeitende Resistzusammensetzung nach Anspruch 1, in der X ein Rest der Formel: 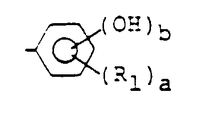 ist, in der R₁, a und b die vorstehend angegebene Bedeutung haben, und α ein zweiwertiger Rest ist, der eine sich wiederholende Einheit der Formel: 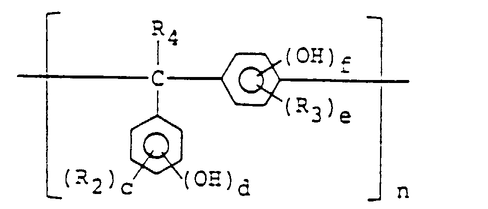 umfaßt, in der R₂, R₃, R₄, d, e, f und n die vorstehend angegebene Bedeutung haben.

3. Positiv arbeitende Resistzusammensetzung nach Anspruch 1, in der n in der Formel (A) nicht kleiner als 1 und nicht größer als 5 ist.

4. Positiv arbeitende Resistzusammensetzung nach Anspruch 4, in der die Polyphenolverbindung (I) mindestens eine Verbindung der Formel: 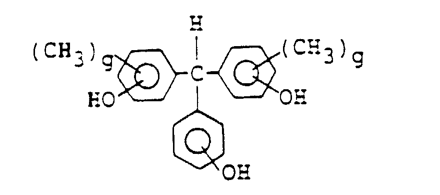 ist, in der g 0, 1 oder 2 ist.

5. Positiv arbeitende Resistzusammensetzung nach Anspruch 4, in der die Polyphenolverbindung (I) die Verbindung der Formel ist:

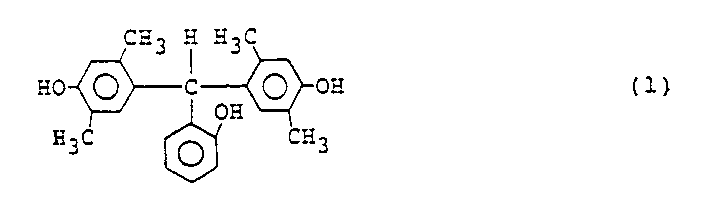

6. Positiv arbeitende Resistzusammensetzung nach Anspruch 4, in der die Polyphenolverbindung (I) die Verbindung der Formel ist:

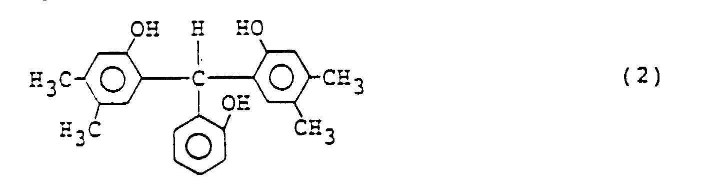

7. Positiv arbeitende Resistzusammensetzung nach Anspruch 4, in der die Polyphenolverbindung (I) die Verbindung der Formel ist:

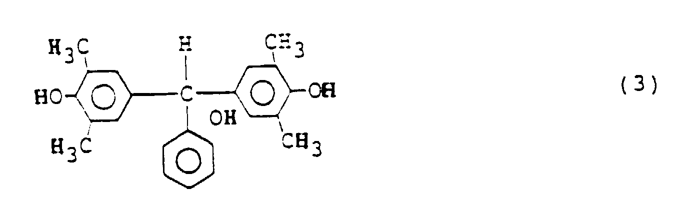

8. Positiv arbeitende Resistzusammensetzung nach Anspruch 1, in der das Novolakharz, das ein Novolakharz mit hohem Molekulargewicht mit einem Gewichtsmittel des Molekulargewichts, gemessen mit GPC, von nicht weniger als 2000, umgerechnet auf Polystyrol, ist, durch Abtrennen von 30 bis 90 Gew.-% der Gewichtsfraktionen mit niedrigem Molekulargewicht, basierend auf dem Gewicht des gesamten Novolakharzes, vom gesamten Harz hergestellt wird.

## Revendications

1. Composition pour réserve de type positif qui comprend un composé 1,2-quinonediazide et une résine novolaque soluble en milieu alcalin ayant une masse moléculaire moyenne en poids mesurée par GPC qui n'est pas inférieure à 2 000 telle que convertie en polystyrène, qui est un produit de condensation d'un composé phénolique et de formaldéhyde et d'un composé polyphénolique (I) de formule générale :
X-α-H (I)
dans laquelle X est un groupe de formule : 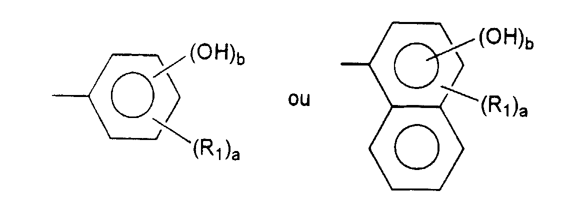 et α est un groupe divalent qui comprend une unité répétitive de formule (A): 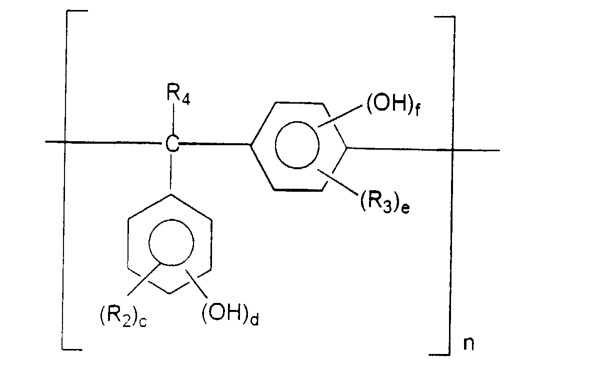 ou 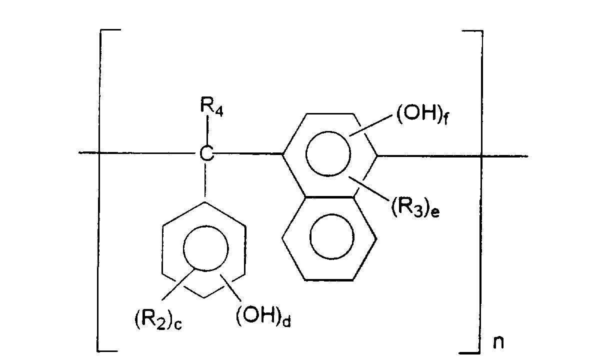 dans laquelle n est un nombre qui n'est pas inférieur à 1 ; a, b, c, d, e et f sont identiques où différents et sont un nombre de O à 3, à condition que d + f ne soit pas inférieur à 1 ; R₁, R₂ et R₃ sont semblables ou différents et sont un groupe alkyle en C₁-C₁₈, un groupe alcoxy en C₁-C₁₈, un groupe carboxyle ou un atome d'halogène ; R₄ est un atome d'hydrogène, un groupe alkyle en C₁-C₁₈ ou un groupe aryle, caractérisée en ce que la teneur du composé polyphénolique (I) est de 4 à 40 parties en poids pour 100 parties du poids total de ladite résine novolaque soluble en milieu alcalin et dudit composé polyphénolique (I).

2. Composition pour réserve de type positif selon la revendication 1, caractérisée en ce que X est un groupe de formule: 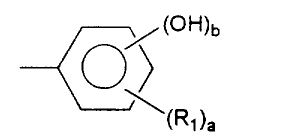 dans laquelle R₁, a et b sont tels que définis ci-dessus, et α est un groupe divalent qui comprend une unité répétitive de formule: 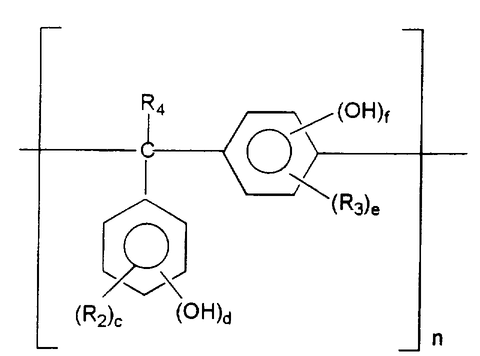 dans laquelle R₂, R₃, R₄, d, e, f et n sont les mêmes que définis ci-dessus.

3. Composition pour réserve de type positif selon la revendication 1, caractérisée en ce que n dans la formule (A) n'est pas inférieur à 1 et n'est pas supérieur à 5.

4. Composition pour réserve de type positif selon la revendication 1, caractérisée en ce que le composé polyphénolique (I) est au moins un composé de formule: 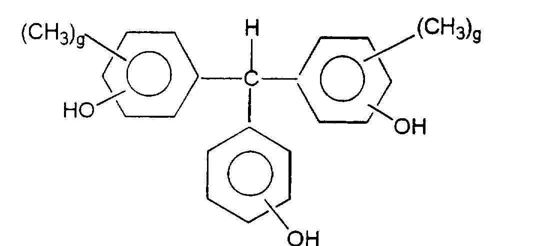 dans laquelle g est égal à 0, 1 ou 2.

5. Composition pour réserve de type positif selon la revendication 4, caractérisée en ce que le composé polyphénolique (I) est le composé de formule:

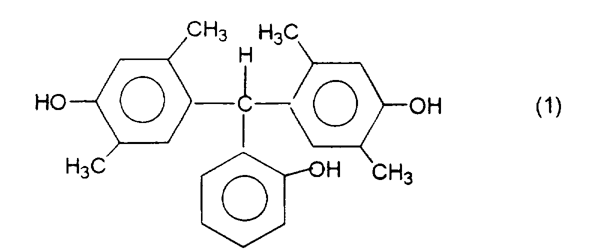

6. Composition pour réserve de type positif selon la revendication 4, caractérisée en ce que le composé polyphénolique (I) est le composé de formule:

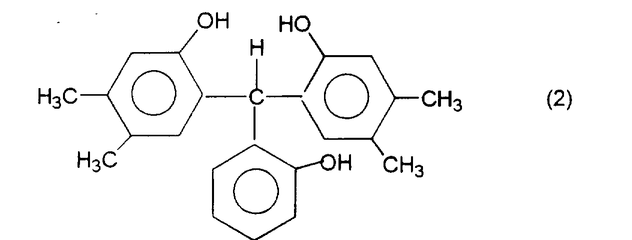

7. Composition pour réserve de type positif selon la revendication 4, caractérisée en ce que le composé polyphénolique (I) est le composé de formule:

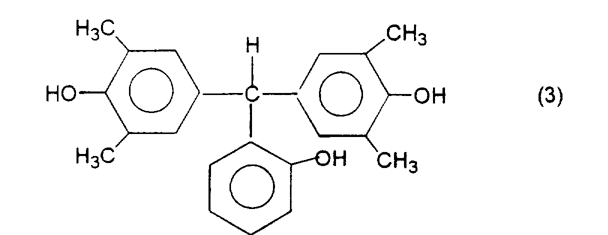

8. Composition pour réserve de type positif selon la revendication 1, caractérisée en ce que la résine novolaque, qui est une résine novolaque ayant une masse moléculaire moyenne en poids mesurée par GPC qui n'est pas inférieure à 2 000 telle que convertie en polystyrène, est préparée par élimination de toute la résine de 30 à 90 % en poids des fractions de masse moléculaire faible sur la base du poids de toute la résine novolaque.
